## Europäisches Patentamt
## European Patent Office
## Office européen des brevets

(19)

(11) Numéro de publication: **0 082 065**
**B1**

(12) # FASCICULE DE BREVET EUROPEEN

(45) Date de publication du fascicule du brevet:
**24.07.85**

(51) Int. Cl.⁴: **H 03 K 19/003**, H 03 K 19/16

(21) Numéro de dépôt: **82402234.7**

(22) Date de dépôt: **07.12.82**

(54) **Dispositif de déclenchement d'un actionneur de sûreté.**

(30) Priorité: **11.12.81 FR 8123203**

(43) Date de publication de la demande:
**22.06.83 Bulletin 83/25**

(45) Mention de la délivrance du brevet:
**24.07.85 Bulletin 85/30**

(84) Etats contractants désignés:
**BE DE FR GB IT**

(56) Documents cités:
**DE - B - 1 196 229**
**GB - A - 838 809**
**GB - A - 1 336 296**

**TECHNISCHE RUNDSCHAU, vol. 60, no. 54, 27 décembre 1968, pages 24-28, Bern (CH); P. SCHNEIDER: "Logische Schaltungen" AUTOMATISME, vol. II, no. 9, septembre 1957, pages 344-351, Paris (FR); R.A. MATHIAS et al.: "Les dispositifs statiques de commutation" BULLETIN DE LA SOCIETE FRANCAISE DES ELECTRICIENS, vol. 1, no. 10, octobre 1960, pages 711-720, Paris (FR); M.F. VERSINI: "Contribution a la comparaison des propriétés des circuits logiques statiques à éléments de base magnétique et à élément de base transistor pour automatismes industriels"**

(73) Titulaire: **COMMISSARIAT A L'ENERGIE ATOMIOUE Etablissement de Caractère Scientifique Technique et Industriel, 31/33, rue de la Fédération, F-75015 Paris (FR)**
Titulaire: **FRAMATOME ET CIE., Tour Fiat 1, Place de la Coupole, F-92400 Courbevoie (FR)**
Titulaire: **MERLIN GERIN, Rue Henri Tarze, F-38050 Grenoble Cedex (FR)**

(72) Inventeur: **Bessedine, Anatole, Murianette, F-38420 Domene (FR)**

(74) Mandataire: **Mongrédien, André et al, c/o BREVATOME 25, rue de Ponthieu, F-75008 Paris (FR)**

## Description

La présente invention concerne un dispositif de déclenchement d'un actionneur de sûreté. Elle s'applique notamment au déclenchement de tout actionneur de sûreté et aux actionneurs de sûreté qui permettent de déclencher une action de protection dans un réacteur nucléaire.

On sait qu'un réacteur nucléaire par exemple comprend un grand nombre de dispositifs qui permettent de contrôler son fonctionnement. Ces dispositifs sont qualifiés d'actionneurs de sûreté. En cas d'incident, ces actionneurs doivent pouvoir être déclenchés de façon urgente, de façon que leur action de protection puisse arrêter cet incident. Dans les réacteurs nucléaires, on mesure les valeurs d'un certain nombre de grandeurs physiques, telles que la pression, la température, le flux neutronique, etc., en un certain nombre de points. On compare ensuite dans différents appareils les valeurs de ces grandeurs avec des valeurs de référence. Ces appareils délivrent normalement des signaux logiques de comparaisons, de valeur non nulle, lorsque les valeurs des grandeurs physiques sont situées dans une fourchette de valeurs définies à l'avance, correspondant au fonctionnement normal du réacteur. Lorsque les grandeurs physiques sortent de cette fourchette de sécurité, ces appareils délivrent des signaux logiques de sortie, de valeurs nulles par exemple. Ce sont les signaux de sortie de ces appareils qui sont appliqués à des dispositifs de déclenchement d'actionneurs de sûreté. Dans certaines réalisations, ces dispositifs de déclenchement sont des dispositifs logiques de type 2/2 qui permettent de déclencher une action urgente par un signal fourni sur une sortie, ce signal présentant, par exemple, l'état logique 1, lorsque deux de ses entrées reçoivent des signaux de commande dont l'état logique est 0 ; ces signaux de commande proviennent des appareils mentionnés plus haut.

On connaît des dispositifs de déclenchement d'actionneurs de sûreté comprenant des moyens de déclenchement constitués, par exemple, par une porte OU à sortie inversée, deux des entrées de cette porte étant reliées respectivement aux sorties de deux portes ET à deux entrées. Ces portes reçoivent chacune, sur l'une de leurs entrées de commande, un signal de commande provenant des appareils mentionnés plus haut, tandis qu'une autre entrée peut recevoir un signal de test qui permet d'imposer, à la sortie de la porte OU, un signal d'état logique 1 prédéterminé, quel que soit l'état logique des signaux de commande appliqués sur chacune des entrées de commande des deux portes ET.

Ces dispositifs de type connu ont pour principal inconvénient de ne pouvoir commander que des actionneurs de faible puissance. Or, dans beaucoup de domaines et notamment dans les réacteurs nucléaires, les actionneurs de sûreté nécessitent une puissance assez importante qu'il est impossible d'obtenir à l'aide de circuits logiques de type intégré sur substrat semi-conducteur.

La présente invention a pour but de remédier à ces inconvénients et notamment de réaliser un dispositif de déclenchement d'un actionneur de sûreté présentant une puissance de sortie plus importante que celle qui peut être obtenue à l'aide de dispositifs comprenant des circuits intégrés.

L'invention a pour objet un dispositif de déclenchement d'un actionneur de sûreté comprenant des moyens de déclenchement dont une sortie fournit un signal de sortie pouvant présenter deux états logiques, l'un de ces états correspondant au déclenchement de l'actionneur, et l'autre état correspondant à l'absence de déclenchement de celui-ci, des moyens de test et de commande de ces moyens de déclenchement, ces moyens de test et de commande comportant deux entrées de commande recevant des signaux de commande des moyens de déclenchement pour que le signal de sortie présente l'un des deux états logiques, et une entrée de test recevant un signal de test pour que ladite sortie fournisse un signal de sortie dont l'état logique correspond au déclenchement de l'actionneur même si les signaux de commande provoquent la fourniture d'un signal de sortie correspondant à l'absence de déclenchement, caractérisé en ce que les moyens de test et de commande sont constitués par trois enroulements primaires d'un amplificateur magnétique, deux de ces enroulements primaires recevant des courants continus correspondant aux signaux de commande, un autre de ces enroulements étant un enroulement de test recevant un courant continu correspondant au signal de test, les moyens de déclenchement étant constitués par un enroulement secondaire de l'amplificateur magnétique, cet enroulement secondaire étant relié à une source électrique de tension alternative, l'actionneur étant relié à cet enroulement par l'intermédiaire d'un pont redresseur.

Selon un mode de réalisation particulier de l'invention, les nombres d'ampères-tours des enroulements sont choisis de manière que, lorsque les nombres d'ampères-tours des enroulements primaires sont nuls, l'intensité moyenne du courant correspondant au signal de sortie appliqué au déclencheur est maximum et correspond à l'état logique de déclenchement de l'actionneur, cette intensité étant inférieure à un seuil prédéterminé et correspondant à l'état logique d'absence de déclenchement de l'actionneur lorsque les nombres d'ampères-tours des enroulements de commande sont tous les deux, ou l'un ou l'autre, supérieurs à une valeur prédéterminée alors que le nombre d'ampères-tours de l'enroulement de test est nul, cette intensité étant maximum et correspondant à l'état logique de déclenchement de l'actionneur lorsque les nombres d'ampères-tours des enroulements de commande étant tous les deux, ou l'un ou l'autre, supérieurs à une valeur prédéterminée alors que le nombre d'ampères-tours de l'enroulement de test est supérieur à une valeur prédéterminée.

Selon une variante de ce mode particulier, le nombre de spires de l'enroulement de test est double du nombre de spires de chaque enroulement de commande, les intensités des courants circulant dans les enroulements de commande et dans l'enroulement de test étant égales lorsque les nombres d'ampères-tours de ces enroulements sont supérieurs aux valeurs prédéterminées, le sens du courant dans l'enroulement de test étant opposé au sens des courants dans chaque enroulement de commande.

Selon un autre mode particulier, la source de tension est une source de tension sinusoïdale, le pont redresseur étant un pont redresseur double alternance.

Les caractéristiques et avantages de l'invention ressortiront mieux de la description qui va suivre, données en référence aux dessins annexés dans lesquels:

— la fig. 1 représente un dispositif connu de déclenchement d'un actionneur de sûreté, comportant des circuits intégrés sur substrats semiconducteurs;

— la fig. 2 représente schématiquement un dispositif de déclenchement conforme à l'invention;

— la fig. 3 est un diagramme qui représente la variation de l'intensité du courant moyen redressé circulant dans l'actionneur, en fonction des nombres d'ampères-tours des enroulements primaires de l'amplificateur magnétique du dispositif de l'invention.

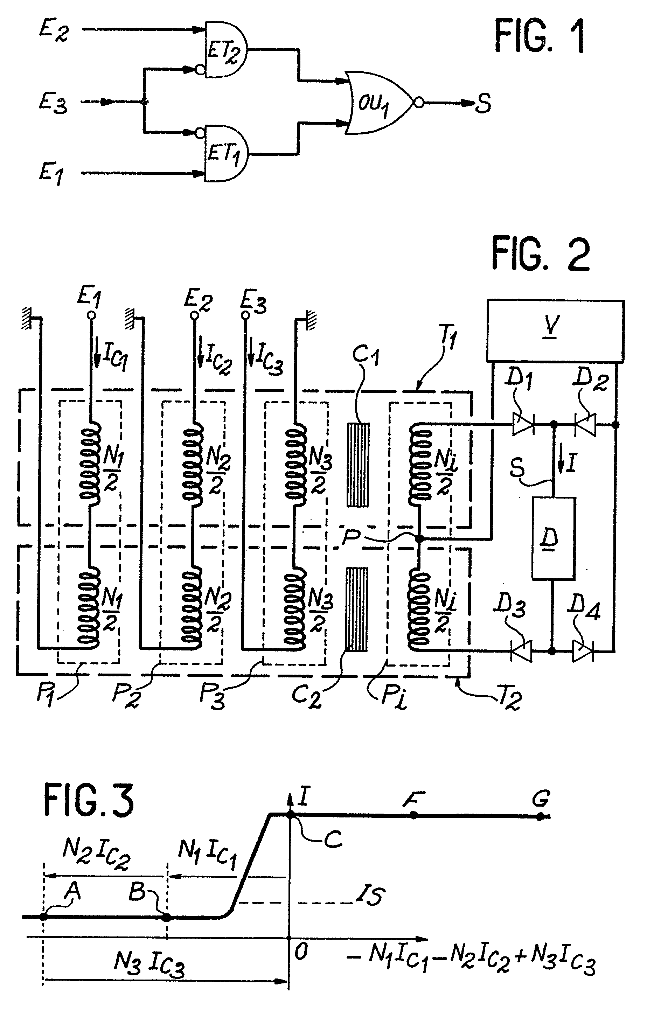

La fig. 1 représente schématiquement un dispositif de déclenchement d'un actionneur de sûreté, connu dans l'état de la technique et constitué par des circuits logiques de faible puissance, de type intégré sur substrat semi-conducteur. Ce dispositif comprend des moyens de déclenchement, constitués par une porte OU1 dont une sortie S fournit un signal de sortie qui peut présenter deux états logiques 0 ou 1; l'un de ces états (l'état logique 1 par exemple) correspond au déclenchement d'un actionneur de sûreté recevant le signal fourni par la sortie S et l'autre état (0 par exemple) correspond à l'absence de déclenchement de cet actionneur. Ce dispositif comprend aussi des moyens de test et de commande des moyens de déclenchement; ces moyens de test et de commande sont constitués ici par les portes logiques ET1 et ET2. Ces portes comprennent des entrées E1 et E2 de commande qui reçoivent respectivement des signaux de commande des moyens de déclenchement (porte OU1); ces signaux de commande proviennent des appareils décrits plus haut et qui permettent de comparer, avec des valeurs de référence, les valeurs de paramètres fournies par des capteurs de mesure. Les deuxièmes entrées de ces portes (référencées E3) sont des entrées de test qui reçoivent un signal de test. L'état logique de ce signal de test est tel que, quels que soient les états logiques des signaux de commande appliqués sur les entrées E1 et E2, la sortie S du dispositif fournit un signal dont l'état logique (1 par exemple) correspond au déclenchement de l'actionneur. Les entrées de test des portes ET1 et ET2 sont des entrées inversées, tandis que la sortie de la porte OU est une sortie inversée.

La table logique ci-dessous représente les états logiques des signaux en différents points du dispositif et permet de mieux comprendre le fonctionnement de celui-ci:

| E1 | E2 | E3 | S |
|----|----|----|---|
| 1 | 1 | 0 | 0 |
| 0 | 1 | 0 | 0 |
| 1 | 0 | 0 | 0 |
| 0 | 0 | 0 | 1 |
| 1 | 0 | 1 | 1 |
| 0 | 1 | 1 | 1 |
| 1 | 1 | 1 | 1 |
| 0 | 0 | 1 | 1 |

Dans cette table, l'état logique 0 représente une absence d'information ou de tension, tandis que l'état logique 1 représente une présence d'information ou de tension. On remarque dans cette table que, lorsque l'entrée de test E3 reçoit un signal de niveau logique 0, la sortie S du dispositif reste à l'état logique 0 tant que les deux entrées E1 et E2 de commande, ou l'une au moins de ces deux entrées, reçoivent des signaux à l'état logique 1.

Pour que le signal de la sortie S du dispositif passe à l'état logique 1, correspondant au déclenchement d'un actionneur, il est nécessaire que les deux entrées E1 et E2 reçoivent simultanément un signal à l'état logique 0. Ce cas apparaît sur les quatrième et huitième lignes de la table. On voit dans ce cas que, si les deux entrées E1 et E2 reçoivent un signal de commande, d'état logique 0, un signal de déclenchement d'état logique 1 est disponible sur la sortie S du dispositif, quel que soit l'état logique du signal de test appliqué sur l'entrée de test E3 du dispositif.

Les cinquième, sixième et septième lignes de la table montrent que, dans le cas où l'entrée de test E3 reçoit un signal de test présentant l'état logique 1, la sortie S du dispositif reste à l'état logique 1, même si les deux entrées de commande E1 et E2 ou l'une au moins de ces entrées reçoit un signal qui est à l'état logique 1. Il en résulte que l'application d'un signal de test à l'état logique 1 sur l'entrée de test E3 du dispositif provoque l'apparition d'un signal de déclenchement d'état logique 1, sur la sortie du dispositif, quel que soit l'état logique des signaux de commande appliqués sur les entrées E1 et E2.

La fig. 2 représente schématiquement un dispositif de déclenchement d'un actionneur de sûreté, conforme à l'invention, dont le fonctionnement répond à la table logique précédente. Ce dispositif, qui sera décrit plus loin en détail, comprend des moyens de déclenchement et des moyens de commande et de test de ces moyens de déclenchement; les moyens de test permettant, lorsqu'ils reçoivent un signal de test d'état logique prédéterminé, de commander les moyens de déclenchement pour que ceux-ci fournissent sur leur sortie un signal correspondant au déclenchement d'un actionneur de sûreté. Ce signal de déclenchement apparaît même si les signaux de commande appliqués aux moyens de commande correspondent normalement à l'absence de déclenchement de l'actionneur. Dans ce dispositif, les moyens de test et de commande appliqués aux moyens de commande correspondent normalement à l'absence de déclenchement de l'actionneur. Dans ce dispositif, les moyens de test et de commande ainsi que les moyens de déclenchement sont des parties d'un amplificateur magnétique constitué par deux transformateurs identiques T1 et T2, toroïdaux, à cycle d'hystérésis rectangulaire. Deux des enroulements primaires P1 de chacun de ces transformateurs, connectés en série forment un enroulement $P_1$ recevant des signaux de commande sur son entrée $E_1$. De même deux autres enroulements primaires connectés en série de chacun de ces transformateurs forment un enroulement P2 recevant des signaux de commande sur son entrée E2; ces signaux correspondent à des courants IC1, IC2. Un troisième enroulement primaire P3 du transformateur est un enroulement de test qui reçoit, sur une entrée E3, un courant de test IC3 correspondant au signal de test décrit plus haut. Ce courant peut être fourni par une source électrique de courant, non représentée. Sur cette figure, $\dfrac{N1}{2}$, $\dfrac{N2}{2}$, $\dfrac{N3}{2}$ désignent les nombres de spires des enroulements primaires de chaque transformateur constituant l'amplificateur magnétique. Les moyens de déclenchement sont constitués par l'enroulement secondaire Pi de l'amplificateur magnétique qui comprend ici les deux enroulements identiques des secondaires des transformateurs T1 et T2. $\dfrac{Ni}{2}$ désigne sur cette figure le nombre de spires de chaque enroulement secondaire des transformateurs T1 et T2. L'enroulement secondaire de l'amplificateur magnétique est relié à une source V de tension alternative sinusoïdale. Cette source est connectée entre le point commun P des secondaires des transformateurs T1 et T2 et l'une des bornes d'un pont redresseur comprenant les diodes D1, D2, D3, D4, dans la diagonale duquel est branché l'actionneur de sûreté représenté schématiquement en D.

La référence I désigne la valeur moyenne du courant redressé, tandis que $C_1$ et $C_2$ représentent les carcasses magnétiques des transformateurs T1 et T2. Les sens des courants dans les enroulements sont indiqués par des flèches sur la figure. Le sens du courant IC3 dans l'enroulement de test est opposé aux sens des courants IC1 et IC2 dans les enroulements de commande.

La fig. 3 permet de mieux comprendre le fonctionnement du dispositif de l'invention. Cette figure est un diagramme de transfert qui représente les variations de la valeur moyenne du courant redressé I dans l'actionneur D, en fonction de la somme des nombres d'ampères-tours-N1IC1-N2IC2-N3IC3 des enroulements primaires de l'amplificateur magnétique (IC1, IC2, IC3 étant positifs). On suppose, dans un mode préféré de réalisation, que le nombre d'ampères-tours dans l'enroulement secondaire de l'amplificateur, qui correspond au produit du nombre Ni de spires de cet enroulement avec la valeur moyenne de l'intensité du courant redressé I dans l'actionneur D, est égal à la somme algébrique des ampères-tours des enroulements primaires. On suppose d'autre part que le nombre de spires N3 de l'enroulement de test est le double du nombre de spires de chaque enroulement de commande que N3=2N1=2N2. Enfin, les valeurs absolues des intensités des courants continus IC1, IC2, IC3 de commande et de test, circulant dans chacun des trois enroulements primaires, sont égales.

En fait, les nombres d'ampères-tours sont choisis de manière que, lorsque les nombres d'ampères-tours N1IC1, N2IC2, N3IC3 sont nuls (les intensités des courants IC1, IC2, IC3 étant nulles), la valeur de l'intensité du courant moyen I dans l'actionneur, c'est-à-dire en sortie S des moyens de déclenchement, est maximum. Cette intensité maximum correspond à l'apparition d'un signal de déclenchement de l'actionneur, présentant l'état logique 1, tandis que les valeurs nulles des intensités des courants IC1, IC2, IC3 dans chaque enroulement primaire de commande et de test correspondent à des états logiques 0. Ce cas correspond en fait à la quatrième ligne de la table logique décrite plus haut et au déclenchement de l'actionneur par les signaux de commande. Le point de fonctionnement sur le diagramme de transfert de la fig. 3 se situe en C.

La valeur de l'intensité moyenne du courant redressé I circulant dans l'actionneur D est inférieure à un seuil prédéterminé IS, lorsque les nombres d'ampères-tours N1IC1, N2IC2 des enroulements de commande (entrées E1 et E2) sont tous les deux, ou l'un ou l'autre, supérieurs à une valeur prédéterminée alors que le nombre d'ampères-tours N3IC3 (entrée E3) de l'enroulement de test est nul. Ce cas correspond aux trois premières lignes de la table logique décrite plus haut.

L'intensité du courant IC3 dans l'enroulement de test étant nulle, cela correspond à un signal de test d'état logique 0, appliqué à l'enroulement de test; les intensités des courants IC1 et IC2 sont telles que les nombres d'ampères-tours N1 IC1, N2, IC2 dans les deux enroulements de commande sont tous les deux, ou l'un ou l'autre, supérieurs à une valeur prédéterminée, cela signifie par exemple que si seul le nombre d'ampères-tours N1IC1 est supérieur à la valeur prédéterminée, alors que les nombres d'ampères-tours N2IC2, N3IC3 sont égaux à 0, le point de fonctionnement se situe en B sur le diagramme de la fig. 3, l'intensité du courant I dans l'actionneur est inférieure au seuil IS; ce cas correspond à la troisième ligne de la table logique décrite plus haut, l'état logique du signal sur la sortie S étant considéré comme étant l'état logique 0.

Le même raisonnement pourrait être tenu pour N2IC2 supérieur à une valeur prédéterminée et, pour N3IC3 et N1IC1 égaux à 0, le cas correspond à la deuxième ligne de la table logique.

Si le nombre d'ampères-tours N3.IC3 dans l'enroulement de test est encore égal à 0, alors que les nombres d'ampères-tours N1.IC1 et N2.IC2 des enroulements de commande sont supérieurs à une valeur prédéterminée, le point de fonctionnement se situe en A sur la fig. 3. La valeur du courant moyen redressé dans l'actionneur D est inférieure au seuil IS et ce cas correspond encore à un signal présentant l'état logique 0 sur la sortie S du dispositif (première ligne de la table logique décrite plus haut).

On va maintenant considérer les différents cas de fonctionnement pour lesquels le nombre d'ampères-tours $N3\,IC3$ de l'enroulement de test est supérieur à une valeur prédéterminée, le point de fonctionnement se situe en C, F ou G sur le diagramme de transfert. Dans ce cas, la valeur du courant moyen redressé dans l'actionneur D est maximum. Cette valeur correspond à l'application d'un état logique 1 à l'entrée de l'actionneur D. Cet état logique est maintenu quelles que soient les valeurs $N1\,IC1$, $N2\,IC2$ des nombres d'ampères-tours des enroulements de commande. Si les nombres d'ampères-tours $N1\,IC1$, $N2\,IC2$ sont inférieurs à une valeur prédéterminée, les signaux appliqués sur les entrées E1 et E2 peuvent être considérés comme présentant l'état logique 0; le point de fonctionnement se situe en G sur le diagramme de transfert. Ce cas correspond à la huitième ligne de la table logique. L'état logique du signal sur la sortie S est 1. Si, au contraire, les nombres d'ampères-tours $N1.IC1$, $N2\,IC2$ sont supérieurs à une valeur prédéterminée, les signaux appliqués sur les entrées E1 et E2 du dispositif sont considérés comme des signaux d'état logique 1, ce qui correspond à la septième ligne de la table logique. L'état logique du signal sur la sortie S est 1. Le point de fonctionnement est C.

Enfin, si l'un ou l'autre des nombres d'ampères-tours $N1\,IC1$, $N2\,IC2$ est seul supérieur à la valeur prédéterminée, c'est qu'un signal d'état logique 1 est appliqué sur l'une des entrées de commande E1 ou E2 du dispositif, alors qu'un signal d'état logique 0 est appliqué sur l'autre entrée de commande ou réciproquement; ce cas correspond aux cinquième et sixième lignes de la table logique. L'état logique du signal sur la sortie S est 1. Le point de fonctionnement est F.

Il résulte de ces observations que l'application de signaux de test de niveau logique 1 prédéterminé sur l'entrée de test E3 du dispositif provoque la fourniture d'un signal de déclenchement d'état logique 1, sur la sortie S du dispositif, quels que soient les états logiques des signaux appliqués sur les entrées de commande de ce dispositif.

Le dispositif qui vient d'être décrit permet bien de déclencher un actionneur de sûreté nécessitant une puissance de déclenchement supérieure à celle qui peut être fournie par des circuits logiques classiques. Il permet en outre de vérifier que, quels que soient les signaux de commande qui lui sont fournis et grâce à des signaux de test qui lui sont appliqués, l'actionneur peut être déclenché par un signal dont l'état logique correspond à ce déclenchement. Enfin, grâce à ce dispositif, les tests sont «transparents». En effet, quel que soit le signal de test appliqué à l'entrée de test E3, l'action de sécurité (déclenchement de l'actionneur) peut être mise en œuvre par application des signaux déclenchant cette action, sur les entrées E1, E2.

## Revendications

1. Dispositif de déclenchement d'un actionneur de sûreté, comprenant des moyens de déclenchement (Pi) dont une sortie (S) fournit un signal de sortie pouvant présenter deux états logiques, l'un de ces états correspondant au déclenchement de l'actionneur (D), et l'autre état correspondant à l'absence de déclenchement de celui-ci, des moyens de test et de commande (P1, P2, P3) de ces moyens de déclenchement (Pi), ces moyens de test et de commande comportant deux entrées (E1, E2) de commande recevant des signaux de commande des moyens de déclenchement (Pi) pour que le signal de sortie présente l'un des deux états logiques, et une entrée de test (E3) recevant un signal de test pour que ladite sortie fournisse un signal de sortie dont l'état logique correspond au déclenchement de l'actionneur (D) même si les signaux de commande provoquent la fourniture d'un signal de sortie correspondant à l'absence de déclenchement, caractérisé en ce que les moyens de test et de commande (P1, P2, P3) sont constitués par trois enroulements primaires d'un amplificateur magnétique, deux de ces enroulements primaires (P1, P2) recevant des courants continus correspondant aux signaux de commande, un autre de ces enroulements (P3) étant un enroulement de test recevant un courant continu correspondant au signal de test, les moyens de déclenchement étant constitués par un enroulement secondaire (Pi) de l'amplificateur magnétique, cet enroulement secondaire étant relié à une source électrique (V) de tension alternative, l'actionneur (D) étant relié à cet enroulement par l'intermédiaire d'un pont redresseur (D1, D2, D3, D4).

2. Dispositif selon la revendication 1, caractérisé en ce que les nombres d'ampères-tours des enroulements sont choisis de manière que, lorsque les nombres d'ampères-tours des enroulements primaires (P1, P2, P3) sont nuls, l'intensité moyenne du courant (I) correspondant au signal de sortie appliqué au déclencheur (D) est maximum et correspond à l'état logique de déclenchement de l'actionneur, cette intensité étant inférieure à un seuil prédéterminé (IS) et correspondant à l'état logique d'absence de déclenchement de l'actionneur, lorsque les nombres d'ampères-tours des enroulements de commande (P1, P2) sont tous les deux, ou l'un ou l'autre, supérieurs à une valeur prédéterminée alors que le nombre d'ampères-tours de l'enroulement de test (P3) est nul, cette intensité étant maximum et corespondant à l'état logique de déclenchement de l'actionneur (D) lorsque les nombres d'ampères-tours des enroulements de commande (P1, P2) étant tous les deux, ou l'un ou l'autre, supérieurs à une valeur prédéterminée, le nombre d'ampères-tours de l'enroulement de test (P3) est supérieur à une valeur prédéterminée.

3. Dispositif selon la revendication 2, caractérisé en ce que le nombre de spires (N3) de l'enroulement de test (P3) est double du nombre de spires (N1, N2) de chaque enroulement de commande (P1, P2), les intensités (IC1, IC2, IC3) des courants circulant dans les enroulements de commande et dans l'enroulement de test étant égales lorsque les nombres d'ampères-tours de ces enroulements sont supérieurs aux valeurs prédéterminées, le sens du courant (IC3) dans l'enroulement de test étant opposé au sens des courants (IC1, IC2) dans chaque enroulement de commande.

4. Dispositif selon la revendication 2, caractérisé en ce que le pont redresseur (D1, D2, D3, D4) est un pont redresseur double alternance.

## Patentansprüche

1. Auslösevorrichtung für einen Sicherheitsanreger, mit Auslösemitteln (Pi), von denen ein Ausgang (S) ein Ausgangssignal bereitstellt, welches zwei logische Zustände aufweisen kann, von denen einer der Auslösung des Anregers (D) und der andere dem Fehlen dessen Auslösung entspricht, Prüf- und Steuermitteln (P1, P2, P3) für diese Auslösemittel (Pi), wobei die Prüf- und Steuermittel zwei Steuereingänge (E1, E2), die Steuersignale von den Auslösemitteln (Pi) erhalten, damit das Ausgangssignal einen der zwei logischen Zustände aufweist, und einen Prüfeingang (E3) aufweisen, der ein Prüfsignal erhält, damit der Ausgang ein Ausgangssignal abgibt, dessen logischer Zustand der Auslösung des Anregers (D) selbst dann entspricht, wenn die Steuersignale die Bereitstellung eines Ausgangssignals bewirken, welches dem Fehlen der Auslösung entspricht, dadurch gekennzeichnet, dass die Prüf- und Steuermittel (P1, P2, P3) von drei Primärwicklungen eines magnetischen Verstärkers gebildet sind, dass zwei dieser Primärwicklungen (P1, P2) den Steuersignalen entsprechende Gleichströme erhalten, dass eine weitere dieser Wicklungen (P3) eine Prüfwicklung ist, die einen dem Prüfsignal entsprechenden Gleichstrom erhält, dass die Auslösemittel von einer Sekundärwicklung (Pi) des magnetischen Verstärkers gebildet sind, dass diese Sekundärwicklung mit einer elektrischen Wechselspannungsquelle (V) und der Anreger (D) mit dieser Wicklung über eine Gleichrichterbrücke (D1, D2, D3, D4) verbunden ist.

2. Vorrichtung nach Anspruch 1, dadurch gekennzeichnet, dass die Anzahl der Amperewindungen der Wicklungen derart gewählt ist, dass, wenn die Anzahl der Amperewindungen der Primärwicklungen (P1, P2, P3) Null ist, die mittlere Stärke des Stroms (I), die dem an den Auslöser (D) angelegten Ausgangssignal entspricht, maximal ist und dem logischen Zustand der Auslösung des Anregers entspricht, dass diese Stärke unter einer vorbestimmten Schwelle (IS) liegt und dem logischen Zustand beim Fehlen des Auslösens des Anregers entspricht, wenn die Anzahl der Amperewindungen der Steuerwicklungen (P1, P2) bei beiden oder einer von ihnen grösser als ein vorbestimmter Wert ist, während die Anzahl von Amperewindungen der Prüfwicklung (P3) Null ist, dass diese Intensität maximal ist und dem logischen Zustand zum Auslösen des Anregers (D) entspricht, wenn die Anzahl der Amperewindungen der Steuerwicklungen (P1, P2) bei beiden oder bei einer von ihnen grösser als ein vorbestimmter Wert ist, wobei die Anzahl an Amperewindungen der Prüfwicklung (P3) grösser als ein vorbestimmter Wert ist.

3. Vorrichtung nach Anspruch 2, dadurch gekennzeichnet, dass die Windungsanzahl (M3) der Prüfwicklung (P3) gleich dem Doppelten der Windungsanzahl (N1, N2) von jeder Steuerwicklung (P1, P2) ist, dass die Stärken (IC1, IC2, IC3) der in den Steuerwicklungen und der Prüfwicklung fliessenden Ströme gleich gross sind, wenn die Amperewindungsanzahlen dieser Wicklungen grösser als vorbestimmte Werte sind, und dass die Richtung des Stroms (IC3) in der Prüfwicklung den Richtungen der Ströme (IC1, IC2) in jeder Steuerwicklung entgegengesetzt ist.

4. Vorrichtung nach Anspruch 2, dadurch gekennzeichnet, dass die Gleichrichterbrücke (D1, D2, D3, D4) eine Vollweggleichrichterbrücke ist.

## Claims

1. Triggering device for a safety actuator, comprising trigger means (Pi) one output (S) of which provides an output signal in one of two logic states, one of said states corresponding to triggering of the actuator (D), and the other corresponding to the absence of triggering, test and command means (P1, P2, P3) for the trigger means (Pi), said test and command means having two command inputs (E1, E2) receiving command signals from said trigger means (Pi) so that the output signal is in one of the two logic states, and a test input (E3) receiving a test signal so that said output provides an output signal whose logic state corresponds to triggering of the actuator (D) even if the command signals lead to provision of an output signal corresponding to the absence of triggering, characterized in that the test and command means (P1, P2, P3) comprise three primary windings of a magnetic amplifier, two of said primary windings (P1, P2) receiving continuous currents corresponding to the command signals, another of said windings (P3) being a test winding receiving a continuous current corresponding to the test signal, the trigger means comprising a secondary winding (Pi) of the magnetic amplifier, said secondary winding being connected to an alternating current source (V), the actuator (D) being connected to said winding through a rectifier bridge (D1, D2, D3, D4).

2. Device according to Claim 1, characterized in that the number of ampere-turns of the windings are selected such that when the number of ampere-turns of the primary windings (P1, P2, P3) are null, the mean current intensity (I) corresponding to the output signal to the trigger (D) is at a maximum and corresponds to the logic state for triggering the actuator, said intensity being below a predetermined threshold (IS) and corresponding to the logic state for no triggering of the actuator, and when the numbers of ampere-turns of the command windings (P1, P2) are either or both greater than a predetermined value, while the number of ampere-turns of the test winding (P3) is null, said intensity being maximum and corresponding to the logic state for triggering the actuator (D) when the numbers of ampere-turns of the command windings (P1, P2) are either or both greater than a predetermined value, the number of ampere-turns of the test winding (P3) is greater than a predetermined value.

3. Device according to Claim 2, characterized in that the number of turns (N3) of the test winding (P3) is double the number of turns (N1, N2) of each command winding (P1, P2), the intensities (IC1, IC2, IC3) of the currents circulating in the command windings and in the test winding being equal when the numbers of ampere-turns of said windings are greater than the predetermined values, the sense of the current (IC3) in the test winding being opposed to the sense of the currents (IC1, IC2) in each command winding.

4. Device according to Claim 2, characterized in that the rectifier bridge (D1, D2, D3, D4) is a double-alternating rectifier bridge.

0 082 065

FIG. 1

FIG. 2

FIG.3

9